# EUROPEAN PATENT APPLICATION

(11) **EP 2 116 918 A1**
(43) Date of publication of application: **11.11.2009**
(21) Application number: 08702975.7
(22) Date of filing: 09.01.2008
(51) Int. Cl.: G06F 1/16, G01D 5/18, G01R 33/09, G09F 9/00, G09G 5/00, G09G 5/36, H01L 43/08

(54) **ELECTRONIC APPARATUS WITH ROTARY SECTION**

(30) Priority: 11.01.2007 JP 2007003734
(71) Applicant: Alps Electric Co., Ltd., Ota-ku Tokyo 145-8501 (JP)
(72) Inventor: TAKEYA, Tsutomu, Tokyo 145-8501 (JP)
(74) Representative: Klunker, Hans-Friedrich
(86) International application number: PCT/JP2008/050104
(87) International publication number: WO 2008/084798

(57) **Abstract**

[OBJECT] To provide an electronic device such as a personal computer for detecting a rotating angle of a rotation unit by a detector utilizing a magnetoresistance effect element.

[SOLUTION] A rotation unit 3 is supported to a device main body unit 2 so as to rotate about a rotation supporting point 6a. The rotation unit 3 is rotated at 180° from a closure posture (a) in tight contact with the device main body unit 2 to a rotation limited position (c). A magnet 8 is fixed to the rotation unit 3 at a position displaced from the rotation supporting point 6a, and the device main body unit 2 is provided with a detector 10 capable of distinctly detecting magnetic fields in two directions of Y1 and Y2. When the rotation unit 3 is rotated from the closure posture (a) at a predetermined angle, a first open detection output is obtained from the detector 10 to turn a display unit provided to the rotation unit 3 ON. When the rotation unit is further rotated to obtain a second open detection output from the detector 10, the display content of the display unit is switched to be turned upside down.

## Description

### Technical Field

The present invention relates to an electronic device including a rotation unit with a display unit, which is capable of detecting a rotating angle of the rotation unit by a detector capable of detecting a direction and an intensity of a magnetic field.

### Background Art

In a book-type personal computer, an in-vehicle display device or the like, a rotation unit with a display unit such as a liquid crystal panel is rotatably mounted to a main body of the aforementioned device. The electronic device of this type is equipped with a sensor for detecting a rotating angle of the rotation unit, and structured to turn the display unit ON/OFF or to switch the display content in response to detection by the sensor with respect to the rotation of the rotation unit at a predetermined angle.

Patent Document 1 discloses a note-type personal computer which allows the angle sensor built-in a hinge portion to detect the rotating angle of the rotation unit. Patent Document 2 discloses the in-vehicle display unit having a rotation unit, which detects the angle of the rotation unit through the encoder type detection method or the micro switch.
Patent Document 1: Japanese Unexamined Patent Application Publication No. 2002-132385
Patent Document 2: Japanese Unexamined Patent Application Publication No. 10-309996

### Disclosure of Invention

### Problems to be Solved by the Invention

The angle sensor and the encoder attached to the hinge portion of the rotation unit may complicate the structure thereof. Each rotation of the rotation unit brings the mechanical components of the angle sensor or the encoder into contact with one another or into the sliding operation. This may unavoidably shorten the life of the angle sensor or the encoder. Additionally the micro switch needs to be attached to the hinge portion of the rotation unit. It is difficult for the hinge portion to have the space sufficient to accommodate the micro switch.

The present invention provides an electronic device with a rotation unit provided with a display unit, which is capable of detecting a rotating angle of the rotation unit by a detector of non-contact/non-sliding type, and easily setting the detection timing.

### Means for Solving the Problems

An electronic device with a rotation unit according to the present invention includes a device main body unit, the rotation unit rotatably supported to the device main body unit, and a display unit provided to the rotation unit. The rotation unit is rotated between a closure posture in which the display unit is directed to the device main body unit and a display posture having the display unit remote from the device main body. A magnet is provided to one of the device main body unit and the rotation unit. A detector is provided to the other. When the rotation unit is rotated at a predetermined angle from the closure posture to the display posture, the detector detects the magnetic field at a predetermined intensity directed to one direction to obtain a first open detection output. When the rotation unit is further rotated to the display posture after obtaining the first open detection output, the detector detects the magnetic field at the predetermined intensity directed to the other direction to obtain a second open detection output.

For example, when the rotation unit is rotated at an angle in excess of 150° from the closure posture, the second open detection output is obtained from the detector.

The electronic device with the rotation unit according to the present invention allows the magnet and the detector to detect the detection state of the rotation unit. The device capable of detecting the direction and intensity of the magnetic field may be used as the single detector to allow detection of the rotating state of the rotation unit at two different angles. As the detector is of non-contact type, it is unlikely to cause the failure irrespective of the prolonged use.

For example, when the first open detection output is obtained by rotating the rotation unit from the closure posture to the display posture, a display of the display unit is turned ON. When the second open detection output is obtained, a display content of the display unit is switched.

The switching of the display content herein means, for example, switching from a still image display to a video display, switching of a display language, and the like.

Alternatively in the present invention, when the first open detection output is obtained by rotating the rotation unit from the closure posture to the display posture, a display of the display unit is turned ON, and when the second open detection output is obtained, a content displayed on the display unit is turned upside down.

As described above, the structure to turn the display content on the display unit upside down is effective for presenting the display content to a person who faces the user by rotating the rotation unit at nearly 180° or higher, that is, for setting the so-called presentation mode.

In the present invention, preferably each angle and each direction of the magnet and the detector are set to have a smaller rotating angle of the rotation unit rotated to reach a rotation limited position in the display posture after obtaining the second open detection output compared with the rotating angle of the rotation unit rotated from the closure posture to a position where the first open detection output is obtained.

The above structure allows the display unit to be turned ON when the rotation unit is rotated relatively largely from the closure posture to have the display unit visually observed, and the display to be switched only when the rotation unit is largely rotated.

In the present invention, when the rotation unit is rotated at a predetermined angle from a rotation limited position in the display posture to the closure posture, a second closure detection output is obtained. When the rotation unit is rotated at a predetermined angle to the closure posture after obtaining the second closure detection output, a first closure detection output is obtained.

In this case, preferably a rotating angle of the rotation unit rotated from the rotation limited position to obtain the second closure detection output is larger than a rotating angle of the rotation unit rotated to reach the rotation limited position after obtaining the second closure detection output.

In this case, for example, when the second closure detection output is obtained by rotating the rotation unit from the rotation limited position to the closure posture, the display content of the display unit is returned to an original state.

In the present invention, preferably, a rotating angle of the rotation unit rotated to reach the closure posture after obtaining the first closure detection output is smaller than a rotating angle of the rotation unit rotated from the closure posture to a position where the first open detection output is obtained.

In this case, for example, when the first closure detection output is obtained by rotating the rotation unit to the closure posture, the display of the display unit is turned OFF.

In the present invention, the detector includes a detection element adapted to utilize a magnetoresistance effect.

### Advantage of the Invention

The present invention allows the rotating posture of the rotation unit with the display unit to be detected at plural positions using a detection unit of non-contact/non-slidable type. The display state may be set in accordance with the rotating angle of the rotation unit. It is also possible to set the timing for obtaining the detection output and the rotating angle of the rotation unit.

### Best Mode for Carrying out the Invention

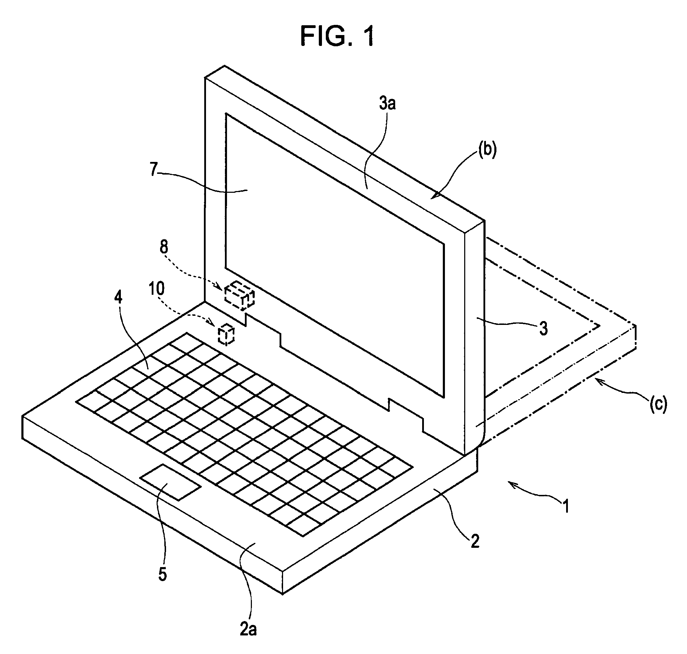

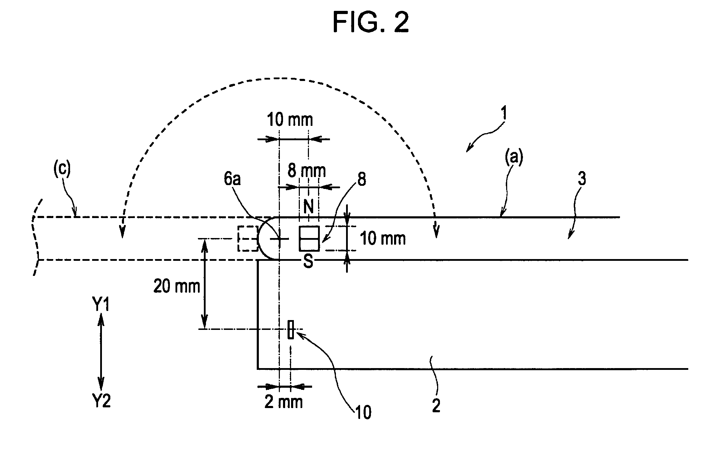

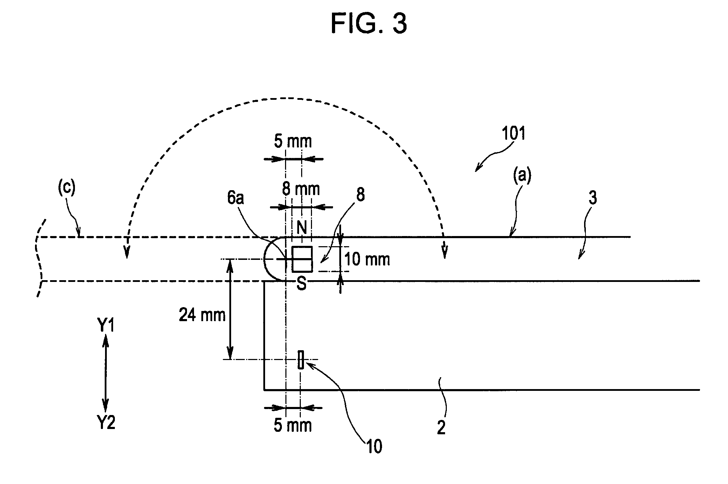

Fig. 1 is a perspective view of an electronic device 1 according to a first embodiment of the present invention. Fig. 2 is a side view of the electronic device 1. Fig. 3 is a side view of an electronic device 101 as a modified example of the first embodiment.

The electronic device 1 illustrated in Fig. 1 is a note-type personal computer which includes a device main body unit 2 and a rotation unit 3. A casing of the device main body unit 2 contains a circuit board on which electronic components constituting a CPU or a memory are mounted. A top surface of the device main body unit 2 is an operation surface 2a, on which a keyboard input unit 4 and a capacitance flat-type input unit 5 are provided.

A display surface 3a of the rotation unit 3 includes a screen of a display unit 7 such as a liquid crystal panel. The rotation unit 3 is rotatably mounted to the device main body unit 2 about a rotation supporting point 6a or 6b illustrated in Figs. 2 and 3. As illustrated in Figs. 2 and 3, the rotation unit 3 may be brought into a closure posture (a) where the display surface 3a with the display unit 7 is overlapped with the opposite operation surface 2a of the device main body unit 2 with almost no gap. In addition, the rotation unit 3 is brought into a display posture as the display surface 3a is rotated to a position remote from the operation surface 2a of the device main body unit 2. Fig. 1 illustrates the display posture (b) where the display surface 3a of the rotation unit 3 is substantially orthogonal to the operation surface 2a of the device main body unit 2. As illustrated by broken lines in Figs. 1 to 3, the rotation unit 3 may be rotated up to a rotation limited position (c) while having the display surface 3a directed above. The rotation unit 3 is rotated from the closure posture (a) to the rotation limited position (c) at the rotating angle of 180°.

The rotation unit 3 is provided with a magnet 8 around the rotation supporting point 6a or 6b, and the device main body unit 2 is provided with a detector 10 for the purpose of detecting the rotating angle of the rotation unit 3. Referring to Figs. 2 and 3, the magnet 8 is set such that the N pole is directed to a Y1 side as an upper side in the thickness direction of the device main body unit 2, and the S pole is directed to a Y2 side as a lower side when the rotation unit 3 is in the closure posture (a).

The detector 10 is capable of detecting the direction and the intensity of the magnetic field utilizing a magnetoresistance effect. It is capable of detecting each magnetic field component in directions of Y1 and Y2 in the thickness direction of the device main body unit 2 while being distinguished from each other, and also capable of detecting each magnetic field intensity in the directions Y1 and Y2.

The structure of the detector 10 will be described hereinafter.

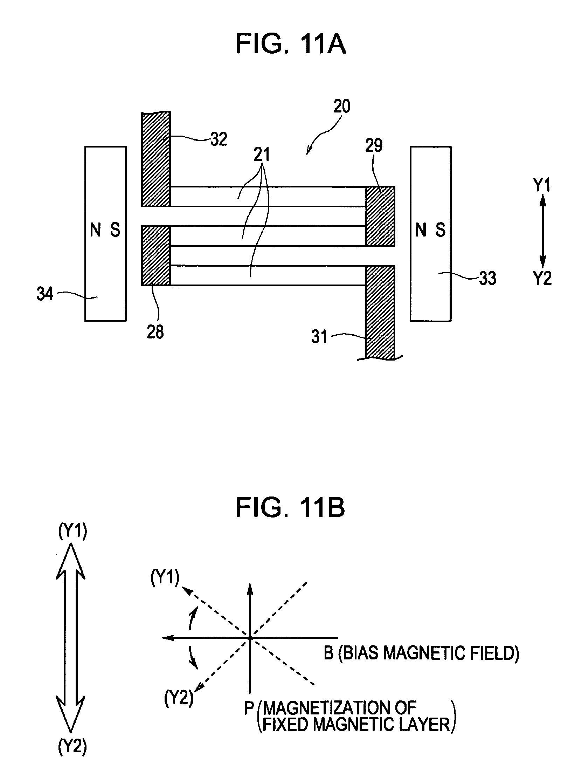

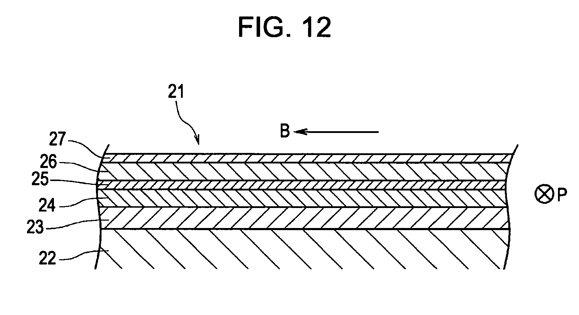

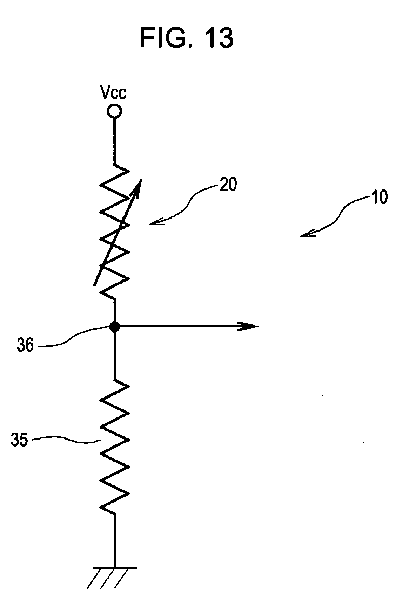

The detector 10 is configured to incorporate a circuit illustrated in Fig. 13 using a magnetoresistance effect element 20 with the structure illustrated in Figs. 11 and 12.

As illustrated in Fig. 11(A), the magnetoresistance effect element 20 includes plural elements 21 formed in parallel with one another. Each of the elements 21 extends having the longitudinal direction orthogonal to the direction Y1-Y2. Each of the elements 21 may be arranged to have the longitudinal direction in parallel to the surface of the drawing as Figs. 2 and 3, or orthogonal to such surface of the drawing.

As illustrated in a cross-sectional view of Fig. 12, each of the respective elements 21 is a giant magnetoresistance effect element (GMR element) formed by laminating an antiferromagnetic layer 23, a fixed magnetic layer 24, a non-magnetic conductive layer 25, and a free magnetic layer 26 in sequential order on a substrate 22 to form a film, and covering an upper surface of the free magnetic layer 26 with a protective layer 27.

The antiferromagnetic layer 23 is formed of an antiferromagnetic material such as an Ir-Mn alloy (iridium-manganese alloy). The fixed magnetic layer 24 is formed of a soft magnetic material such as a Co-Fe alloy (a cobalt-iron alloy). The non-magnetic conductive layer 25 is formed of Cu (copper) or the like. The free magnetic layer 26 is formed of a soft magnetic material such as an Ni-Fe alloy (nickel-iron alloy). The protective layer 27 is formed of Ta (tantalum).

In the elements 21, the magnetizing direction of the fixed magnetic layer 24 is fixed by an antiferromagnetic coupling between the antiferromagnetic layer 23 and the fixed magnetic layer 24. As illustrated in Fig. 11 (B), in the respective elements 21, the fixed direction (direction P) of the magnetization of the fixed magnetic layer 24 is orthogonal to the respective elements 21 extending in the lateral direction. In this embodiment, the fixed direction (direction P) of the magnetization of the fixed magnetic layer 24 corresponds to the direction Y1.

As illustrated in Fig. 11 (A), every two of the elements 21 are coupled by connection electrodes 28 and 29. The elements 21 at the upper and the lower ends in the drawing are connected to extraction electrodes 31 and 32, respectively. The respective elements 21 are connected in series to form a meander pattern.

As illustrated in Fig. 11(A), in the respective elements 21, a magnet 33 is provided at the right side and a magnet 34 is provided at the left side. The bias magnetic field is applied to the elements 21 longitudinally or leftward in the drawing. When the external magnetic field is not applied, the inside of the free magnetic layer 26 is in a single domain condition in a bias direction (direction B) as the longitudinal direction. The bias direction (direction B) is orthogonal to the fixed direction (direction P) of the magnetization of the fixed magnetic layer 24.

As illustrated in Figs. 11(A) and 11(B), the magnetoresistance effect element 20 is capable of detecting the component of the magnetic field in the directions Y1 and Y2 which are orthogonal to the longitudinal direction of the elements 21 distinctively. When the component of the external magnetic field in the direction Y1 is applied to the magnetoresistance effect element 20, the magnetization in the free magnetic layer 26 having the bias magnetic field B active is directed to the same direction as the direction Y1, that is, the fixed direction (direction P) of the magnetization of the fixed magnetic layer 24. At the same time, the electric resistance of the magnetoresistance effect element 20 is decreased. On the contrary, when the component of the external magnetic field in the direction Y2 is applied to the magnetoresistance effect element 20, the magnetization in the free magnetic layer 26 is directed to the direction Y2, that is, the direction opposite the fixed direction (direction P) of the magnetization of the fixed magnetic layer 24. At this time, the electric resistance of the magnetoresistance effect element 20 is increased.

As illustrated in Fig. 13, in the detector 10, the magnetoresistance effect element 20 and the fixed resistance element 35 are connected in series, to which a series voltage Vcc is applied. Then, an intermediate point 36 between the magnetoresistance effect element 20 and the fixed resistance element 35 outputs the detection as an output portion.

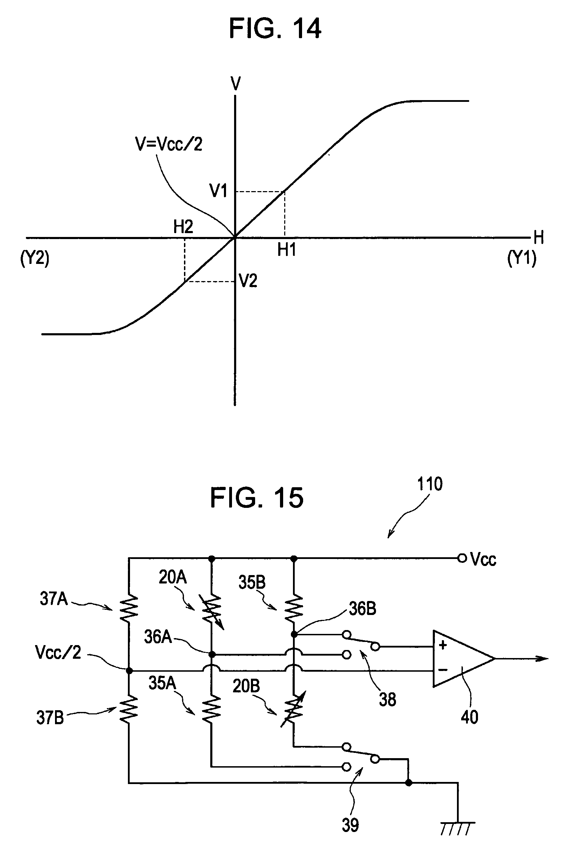

Fig. 14 illustrates a relation of the component and the intensity of the external magnetic field in the directions Y1 and Y2 each acting on the magnetoresistance effect element 20 and the output voltage from the intermediate point 36. The fixed resistance element 35 is formed of the same material with the same thickness as the magnetoreistance effect element 20 illustrated, for example, in Fig. 12, and also the laminating order of the non-magnetic conductive layer 25, and the free magnetic layer 26 is changed so as to have the same temperature characteristic as that of the magnetoresistance effect element 20 without changing the electric resistance due to the external magnetic field. In addition, when the external magnetic field is not active, the resistance value of the fixed resistance element 35 is adjusted such that the detection output from the intermediate point 36 becomes Vcc/2.

As illustrated in Fig. 14, the output voltage from the intermediate point 36 is Vcc/2 when the external magnetic field is not active. The external magnetic field in the direction Y1 acts on the magnetoresistance effect element 20 to increase the output voltage from the intermediate point 36. Meanwhile the external magnetic field in the direction Y2 acts on the magnetoresistance effect element 20 to decrease the output voltage from the intermediate point 36.

As illustrated in Fig. 14, it may be detected that the magnitude of the external magnetic field in the direction Y1 which becomes equal to or larger than a predetermined value H1 based on the recognition that the output voltage from the intermediate point 36 becomes a predetermined value V1. Similarly, it may be determined that the magnitude of the external magnetic field in the direction Y2 becomes equal to or larger than a predetermined value H2 based on the recognition that the output voltage from the intermediate point 36 becomes a predetermined value V2.

The detector 10 illustrated in Fig. 13 uses a single magnetoresistance effect element 20. However, as illustrated in Fig. 15, it is possible to use a detector 110 formed of a circuit using two magnetoresistance effect elements 20A and 20B. The magnetoresistance effect elements 20A and 20B used in the detector 110 are the same as the magnetoresistance effect element 20 illustrated in Figs. 11 and 12. Alternatively, it is also possible to use the detector which is not provided with the magnets 33 and 34 for applying the bias magnetic fields.

In the magnetoresistance effect element 20A, the fixed magnetization (direction P) of the fixed magnetic layer 24 is directed to the direction Y1. Meanwhile, in the other magnetoresistance effect element 20B, the fixed magnetization (direction P) of the fixed magnetic layer 24 is directed to the direction Y2. That is, the magnetoresistance effect element 20A and the magnetoresistance effect element 20B have the same characteristics, but have arrangement oppositely directed with respect to the directions Y1 and Y2.

As illustrated in Fig. 15, in the detector 110, the magnetoresistance effect element 20A and a fixed resistance element 35A are connected in series. In addition, a fixed resistance element 35B and the magnetoresistance effect element 20B are connected in series. Then a direct-current power source voltage Vcc is applied to the magnetoresistance effect element 20A and the fixed resistance element 35A, and the fixed resistance element 35B and the magnetoresistance effect element 20B alternately by way of a switch 39. In addition, a switch 38 operating in synchronization with the switch 39 selects between an intermediate point 36A and an intermediate point 36B alternately. The electric resistance of the fixed resistance element 35A is equal to that of the fixed resistance element 35B.

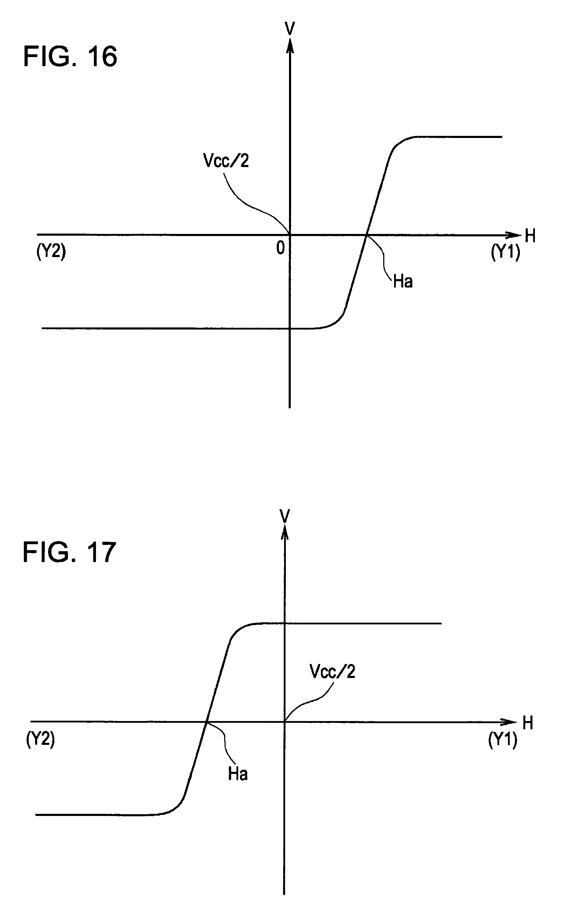

Fig. 16 illustrates the direction and the magnitude of the external magnetic field and a variation characteristic of the voltage at the intermediate point 36A when the direct-current voltage is applied to the magnetoresistance effect element 20A and the fixed resistance element 35A. In addition, Fig. 17 illustrates the direction and the magnitude of the external magnetic field and a variation characteristic of the voltage at the intermediate point 36B when the direct-current voltage is applied to the fixed resistance element 35B and the magnetoresistance effect element 20B.

As illustrated in Fig. 15, the detector 110 includes reference resistances 37A and 37B to which the power source voltage Vcc is applied. A reference voltage at an intermediate point between the reference resistances 37A and 37B is set to Vcc/2. The voltage at the intermediate point 36A and the voltage at the intermediate point 36B may be alternately applied to a positive terminal of a comparator 40 at each switching timing of the switch 39 and the switch 38. In addition, the reference voltage Vcc/2 is applied to a negative terminal of the comparator 40.

A control unit (not shown) is adapted to monitor the output from the comparator 40 when the output voltage from the intermediate point 36A is supplied to the comparator 40 by switching between the switches 38 and 39. When the output becomes positive, it may be determined that the magnitude of the external magnetic field in the direction Y1 becomes equal to or larger than Ha. In addition, the control unit is adapted to monitor the output from the comparator 40 when the output voltage from the intermediate point 36B is supplied to the comparator 40. When the output becomes negative, it may be determined that the magnitude of the magnetic field in the direction Y2 becomes equal to or larger than Hb.

In the electronic device 1 illustrated in Figs. 1 and 2 and the electronic device 101 illustrated in Fig. 3, the detector 10 (or detector 110) detects the magnetic field generated by the magnet 8 which rotates accompanied with the rotation unit 4.

In the electronic device 1 illustrated in Fig. 2 and the electronic device 101 illustrated in Fig. 3, when the rotation unit 3 is in the closure posture (a), the cubic shaped magnet 8 is perpendicularly directed, having the N pole directed upward, and the S pole directed downward. In Figs. 2 and 3, the positional relations between the rotation supporting point 6a and the magnet 8/detector 10, and the rotation supporting point 6b and the magnet 8/detector 10 in the electronic device 1 and the electronic device 101 are respectively illustrated in dimensions (mm).

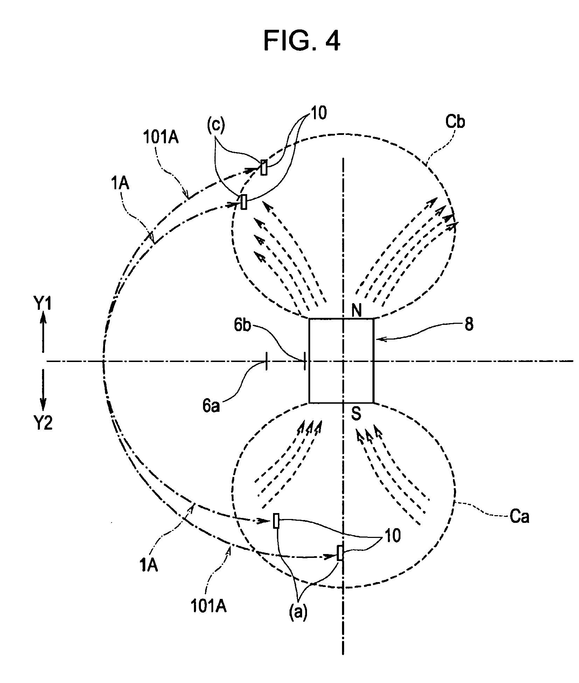

In Fig. 4, the lines of magnetic force generated from the N pole and the lines of magnetic force returning to the S pole are illustrated. Codes Ca and Cb represent isopiestic lines on which the intensity of the component of the magnetic field in the direction Y1 becomes the same value. According to the embodiment illustrated in Fig. 4, the magnetic field intensity in the direction Y1 is approximately 3 mT on the isopiestic lines Ca and Cb, respectively.

Fig. 4 shows the rotation supporting point 6a of the rotation unit 3 in the electronic device 1 illustrated in Fig. 2, and a relative rotation trajectory 1A of the detector 10 with respect to the magnet 8. Fig. 4 also shows the rotation supporting point 6b of the rotation unit 3 in the electronic device 101 illustrated in Fig. 3, and a relative rotation trajectory 101A of the detector 10 with respect to the magnet 8. Each code (a) represents the position of the detector 10 that moves on the rotation trajectory 1A and the rotation trajectory 101A in the closure posture. Each code (c) represents the position of the detector 10 in the rotation limited posture after the rotation at 180°.

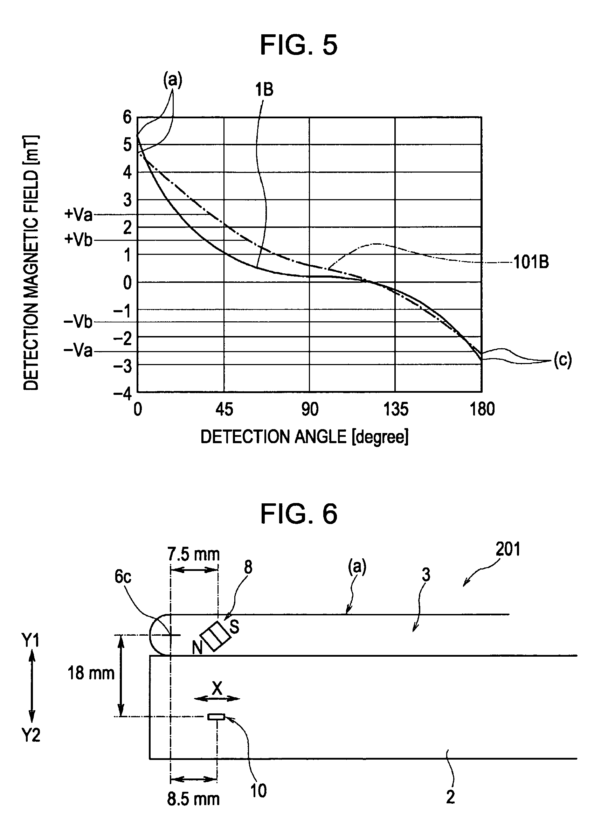

In Fig. 5, a curve 1 B represents a relation between the rotating angle of the rotation unit 3 and the magnetic field intensity detected by the detector 10 in the electronic device 1, and a curve 101 B represents the relation between the rotating angle of the rotation unit 3 and the magnetic field intensity detected by the detector 10 in the electronic device 101. As the direction of the magnetic field which acts on the detector 10 is changed from the closure posture (a) of the rotation unit to the rotation limited position (c) while rotating at 180°, the vertical axis of Fig. 5 shows positive and negative polarities of the magnetic field intensity.

The detector 10 has the output characteristics equivalent to those shown in Fig. 14. In the control unit, four thresholds are set in the detector 10. Thresholds +Va and -Va shown in Fig. 5 are set so as to detect that the absolute values of the magnetic field intensities become 2.5 mT. In addition, thresholds +Vb and -Vb are set so as to detect that the absolute values of the magnetic field intensities become 1.5 mT.

In the electronic device 1 illustrated in Fig. 2 and the electronic device 101 illustrated in Fig. 3, when the rotation unit 3 is rotated at a predetermined angle from the closure posture (a) to the rotation limited position (c), the detection output (output voltage) from the detector 10 is lower than the threshold +Vb. The detection output at this time is set to a first open detection output. When the rotation unit 3 is further rotated, the detection output from the detector 10 exceeds the threshold -Va just before reaching the rotation limited position (c). The detection output at this time is set to a second open detection output.

Next, when the rotation unit 3 is rotated from the rotation limited position (c) to the closure posture (a), the detection output from the detector 10 passes the threshold -Vb. The detection output at this time is set to a second closure detection output. When the rotation unit 3 is further rotated to the closure posture (a), the detection output from the detector 10 passes the threshold +Va. The detection output at this time is set to a first closure detection output.

In the detector 10 used in this embodiment, the absolute values of the thresholds +Va and -Va are equal to each other, and the absolute values of the thresholds +Vb and the threshold -Vb are equal to each other. The detection has a characteristic in the symmetrical form with respect to the point where the magnetic field is zero. Therefore, a detector with a high general versatility may be used as the detector 10. It should be noted that the magnet 8 and the detector 10 are asymmetrically arranged to the positions of the rotation supporting points 6a and 6b, and thus, as illustrated in Fig. 5, in both the electronic devices 1 and 101, the position of the rotation unit 3 when the first open detection output (+Vb) is obtained and the position of the rotation unit 3 when the second open detection output (-Va) is obtained can be set as laterally asymmetric angular postures with respect to the orthogonal direction. In addition, the position of the rotation unit 3 when the second closure detection output (-Vb) is obtained and the position of the rotation unit 3 when the first closure detection output (+Va) is obtained can be set as laterally asymmetric posture with respect to the orthogonal direction.

In the electronic device 1 illustrated in Fig. 2, the rotating angle of the rotation unit 3 rotated from the closure posture (a) to an open posture to obtain the first open detection output (+Vb) is 37°. Furthermore, the rotating angle of the rotation unit 3 from the closure posture (a) to obtain the second open detection output (-Va) is 178°. In addition, in the case where the rotation unit 3 is rotated from the rotation limited position (c) to the closure posture (a), the opening angle of the rotation unit 3 rotated from the closure posture (a) to obtain the second closure detection output (-Vb) is 161°. Furthermore, the opening angle of the rotation unit 3 rotated from the closure posture (a) to obtain the first closure detection output (+Va) is 22°.

In the electronic device 101 illustrated in Fig. 3, the rotating angle of the rotation unit 3 rotated from the closure posture (a) to an open posture to obtain the first open detection output (+Vb) is 60°. Furthermore, the rotating angle of the rotation unit 3 rotated from the closure posture (a) to obtain the second open detection output (-Va) is 177°. In addition, in the case where the rotation unit 3 is rotated from the rotation limited position (c) to the closure posture (a), the opening angle of the rotation unit 3 rotated from the closure posture (a) to obtain the second closure detection output (-Vb) is 164°. Furthermore, the opening angle of the rotation unit 3 rotated from the closure posture (a) to obtain the first closure detection output (+Va) is 38.5°.

As described above, when the rotation unit 3 is rotated from the closure posture (a), the rotating angle from the position to obtain the second open detection output (-Va) is obtained to the rotation limited position (c) is smaller than the rotating angle from the closure posture (a) to obtain the first open detection output (+Vb). Furthermore, the rotating angle of the rotation unit 3 rotated from the position where the second open detection output (-Va) is obtained to the rotation limited position (c) is smaller than the rotating angle of the rotation unit 3 rotated from the closure posture (a) to obtain the first closure detection output (+Va).

In the control unit, when the rotation unit 3 starts rotating from the closure posture (a) to obtain the first open detection output (+Vb), the display unit 7 is turned ON to display information thereon. Then, when the second open detection output (-Va) is obtained, display of the screen on the display unit 7 is inverted at 180° to turn the display screen upside down. The aforementioned structure allows the electronic device 1 to be used in a so-called presentation mode for performing the presentation of the display content on the display unit 7 to a person who faces an operator of the electronic device 1.

As compared with the rotating angle of the rotation unit 3 rotated from the closure posture (a) to obtain the first open detection output (+Vb), the rotating angle of the rotation unit 3 rotated to reach the rotation limited position (c) after obtaining the second open detection output (-Va) is sufficiently small. In the electronic device 1 illustrated in Fig. 2, the rotating angle of the rotation unit 3 rotated to obtain the second open detection output (-Va) is 178°. In the electronic device 101 illustrated in Fig. 3, the rotating angle of the rotation unit 3 rotated to obtain the second open detection output (-Va) is 177°.

In this manner, as the display state of the display unit 7 is switched just before the rotation unit 3 reaches the rotation limited position (c) where the rotating angle becomes 180°, unintentional switching of the display content of the display unit 7 may be prevented when the display unit 7 is directed to the operator who faces the device main body unit 2.

In addition, in the case where the rotation unit 3 at the rotation limited position (c) is rotated to the closure posture (a), the display content of the display unit 7 is returned to the original state when the second closure detection output (-Vb) is obtained. That is, the display content which has been switched to be turned upside down resumes its original state.

When the rotation unit 3 is rotated from the rotation limited position (c) to the closure posture (a), the rotating angle from the rotation limited position (c) to the position where the second closure detection output (-Vb) is obtained is larger than the rotating angle of the rotation unit rotated to reach the rotation limited position (c) after obtaining the second open detection output (-Va). Therefore, when the rotation unit 3 is rotated to the rotation limited position (c), the display content of the display unit 7 is switched to be turned upside down just before reaching the rotation limited position (c). Then, when the rotation unit 3 is returned from the rotation limited position (c), the display content of the display unit 7 is not returned to the original state unless the rotation unit 3 is rotated at the angle to a certain degree. In the electronic device 1 illustrated in Fig. 2, the rotating angle of the rotation unit 3 rotated from the rotation limited position (c) to obtain the second closure detection output (-Vb) is 19°, and in the electronic device 101 illustrated in Fig. 3, the rotating angle is 16°.

The aforementioned structure may be designed to prevent the display content from returning to the original state once the display content of the display unit 7 is switched to be turned upside down irrespective of the slight movement of the rotation unit 3. This makes it possible to prevent the unintentional switching of the display content during the presentation using the switched display content on the display unit 7.

In addition, in the case where the rotation unit 3 is rotated to the closure posture (a), the display of the display unit 7 is turned OFF when the first closure detection output (+Va) is obtained. The rotating angle of the rotation unit rotated from the position where the first closure detection output (+Va) is obtained to turn the display unit 7 OFF to the closure posture (a) is smaller than the rotating angle of the rotation unit 3 rotated from the closure posture (a) to the position where the first open detection output (+Vb) is obtained to turn the display unit 7 ON.

In the case where the rotation unit 3 is rotated from the closure posture (a), the display unit 7 is turned ON subsequent only to relatively a large rotation of the rotation unit 3 to some extent. It is possible to prevent waste of the electric power consumed by unintentionally turning the display unit 7 ON in response to the slight movement of the rotation unit 3. On the other hand, once the display unit 7 is turned ON, it cannot be turned OFF unless the rotation unit 3 is rotated to a position close to the closure posture (a). Therefore, while the information is displayed on the display unit 7, it is possible to prevent the display unit 7 from being turned OFF irrespective of the slight rotation of the rotation unit 3.

In addition, in the electronic device 1 illustrated in Fig. 2 and the electronic device 101 illustrated in Fig. 3, the magnet 8 is arranged at a position remote from the rotation supporting points 6a and 6b so as to be closer to the center of the rotation unit 3 than the rotation supporting points 6a and 6b. The arrangement position of the magnet 8 may be easily selected.

Fig. 6 illustrates an electronic device 201 according to a second embodiment of the present invention.

In the electronic device 201, the rotation unit 3 is provided with the magnet 8, and the detector 10 is disposed inside the device main body unit 2. The magnet 8 is provided at a position closer to the center of the rotation unit 3 than a rotation supporting point 6c. In addition, the magnet 8 is obliquely disposed at 45° with respect to the directions X and Y. When the rotation unit 3 is in the closure posture (a), the N pole side is directed obliquely downward, and the S pole side is directed obliquely upward. In the detector 10 inside the device main body unit 2, the longitudinal direction of the elements 21 illustrated in Fig. 11 (A) is directed orthogonal to the surface of the drawing, and the plural elements 21 are arranged in the direction X. Therefore, the detector 10 is capable of detecting the component of the magnetic field in the direction X generated from the magnet 8. In addition, the positional relation among the rotation supporting point 6c, the magnet 8 and the detector 10 is represented by the dimensions as shown in Fig. 6.

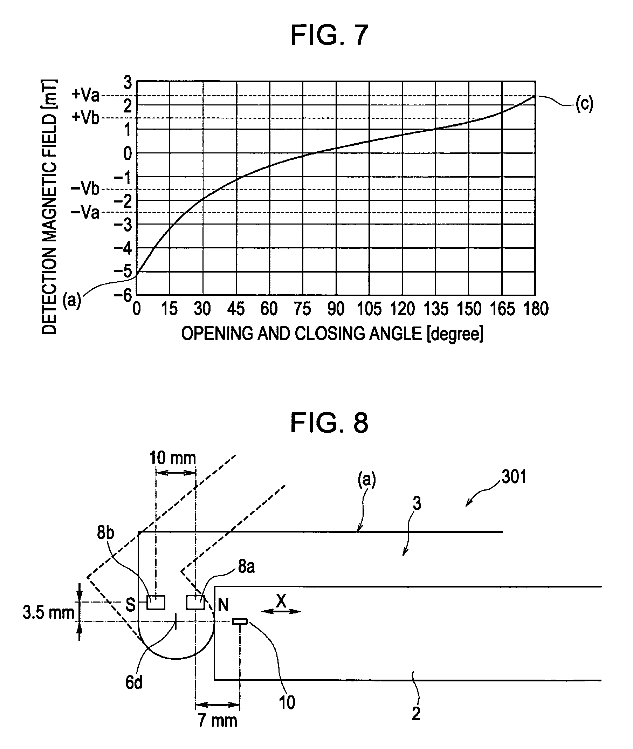

Fig. 7 illustrates a relation between the angle at which the rotation unit 3 is rotated from the closure posture (a) to the rotation limited position (c) and the magnetic field intensity in the direction X detected by the detector 10.

The threshold for obtaining the first open detection output is set to -Vb. The rotating angle of the rotation unit 3 rotated from the closure posture (a) to obtain the first open detection output (+Vb) is 36°. The threshold for obtaining the second open detection output is set to +Va. The rotating angle of the rotation unit 3 rotated from the closure posture (a) to obtain the second open detection output (+Va) is 178°.

The threshold for obtaining the second closure detection output is set to +Vb. The rotating angle of the rotation unit 3 rotated from the closure posture (a) to obtain the second closure detection output is 158°. The threshold for obtaining the first closure detection output is set to -Va. The rotating angle of the rotation unit 3 rotated from the closure posture (a) to obtain the first detection output is 21°.

Therefore, the timings for turning the display unit 7 ON/OFF, and the timing for switching the display content of the display unit 7 can be set similarly to the case of the electronic device 1 illustrated in Fig. 2 and the electronic device 101 illustrated in Fig. 3.

Fig. 8 illustrates an electronic device 301 according to a third embodiment of the present invention.

In the electronic device 301, a rotation supporting point 6d for the rotation unit 3 is located to the rear of the end portion of the device main body unit 2. In the rotation unit 3, two magnets 8a and 8b are provided so as to be separately arranged at the right and left sides respectively remote from the rotation supporting point 6d sandwiched therebetween. The surface of the magnet 8a directed rightward is the N pole. The surface of the magnet 8b directed leftward is the S pole. In the device main body unit 2, the detector 10 is provided to detect the magnetic field in the direction X. The positions of the magnets 8a and 8b, and the detector 10 with respect to the rotation supporting point 6d are shown in the dimensions illustrated in Fig. 8.

In the detector 10, four thresholds are set. As illustrated in Fig. 8, when the rotation unit 3 is in the closure posture (a), the magnets 8a and 8b are positioned above the rotation supporting point 6d, and the detector 10 is positioned at the same height as the rotation supporting point 6d. As a result, the rotating angle of the rotation unit 3 which starts rotating from the closure posture (a) to obtain the first open detection output is 26°. The rotating angle of the rotation unit 3 from the closure posture (a) to obtain the second open detection output is 167°. It should be noted that the rotating angle of the rotation unit rotated to reach the rotation limited position (c) is 180°.

In addition, the opening angle of the rotation unit 3 rotated from the closure posture (a) to obtain the second closure detection output is 154°. The opening angle of the rotation unit 3 rotated from the closure posture (a) to obtain the first closure detection output is 13°.

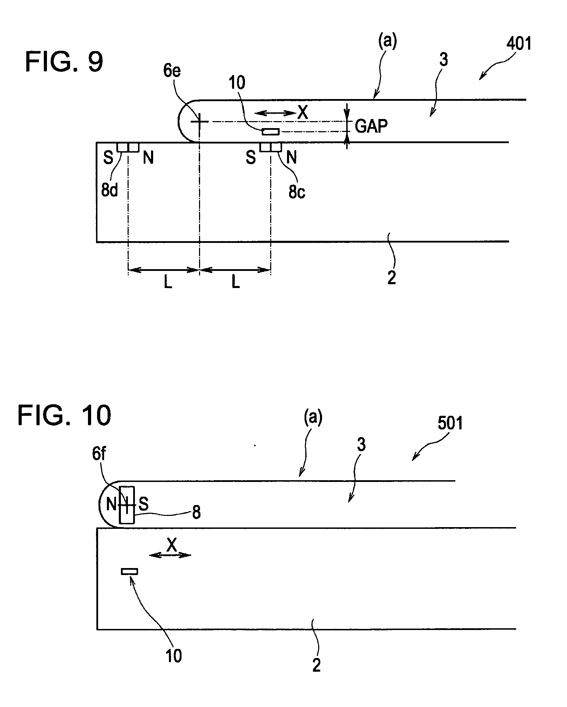

Fig. 9 illustrates an electronic device 401 according to a fourth embodiment of the present invention.

In the electronic device 401, the rotation unit 3 is provided with the detector 10, and the device main body unit 2 is provided with magnets 8c and 8d. When the rotation unit 3 is in the closure posture (a), the detector 10 detects the magnetic field in the direction X. In addition, when the rotation unit 3 is in the closure posture (a), the detector 10 is not at the same height as a rotation supporting point 6e, and the detector 10 is located closer to the device main body unit 2 than the rotation supporting point 6e. The magnets 8c and 8d are arranged to the left and the right sides equally remote from the rotation supporting point 6e therebetween by the distance L.

As illustrated in Fig. 9, when the rotation unit 3 is in the closure posture (a), the detector 10 is positioned lower than the rotation supporting point 6e. The rotating angles for obtaining the first and the second open detection outputs and the rotating angles for obtaining the second and the first closure detection outputs can be set similarly to the electronic devices 1, 101, 201, and 301 according to the above-described respective embodiments.

Fig. 10 illustrates an electronic device 501 according to a fifth embodiment of the present invention.

According to the embodiment, in the rotation unit 3, the magnet 8 is positioned at the level on a rotation center of a rotation supporting point 6f. In the device main body unit 2, the detector 10 is positioned just below the rotation supporting point 6f. The detector 10 detects the magnetic field detected in the direction X.

In the electronic device 501 illustrated in Fig. 10, the rotating angle of the rotation unit rotated from the closure posture (a) to obtain the first open detection output is the same as the rotating angle of the rotation unit rotated to reach the rotation limited position (c) after obtaining the second open detection output.

### Brief Description of the Drawings

[Fig. 1] Fig. 1 is a perspective view of an electronic device according to a first embodiment of the present invention.
[Fig. 2] Fig. 2 is a side view of the electronic device according to the first embodiment of the present invention.
[Fig. 3] Fig. 3 is a side view of an electronic device according to a modified example of the first embodiment.
[Fig. 4] Fig. 4 is an explanatory diagram for describing a positional relation between a magnet and a detector in the electronic device according to the first embodiment and the modified example thereof.
[Fig. 5] Fig. 5 is a diagram of a relation between a rotating angle of a rotation unit and an output from a detector in the electronic device according to the first embodiment and the modified example thereof.
[Fig. 6] Fig. 6 is a side view of an electronic device according to a second embodiment of the present invention.
[Fig. 7] Fig. 7 is a diagram of a relation between the rotating angle of the rotation unit and the output from the detector in the electronic device according to the second embodiment.
[Fig. 8] Fig. 8 is a side view of an electronic device according to a third embodiment of the present invention.
[Fig. 9] Fig. 9 is a side view of an electronic device according to a fourth embodiment of the present invention.
[Fig. 10] Fig. 10 is a side view of an electronic device according to a fifth embodiment of the present invention.
[Fig. 11] Fig. 11(A) is a plan view of a structure of a magnetoresistance effect element. Fig. 11 (B) is an explanatory diagram for describing a magnetization direction of a fixed magnetic layer of the magnetoresistance effect element and a direction of a bias magnetic field.
[Fig. 12] Fig. 12 is a cross-sectional view of an element of the magnetoresistance effect element.
[Fig. 13] Fig. 13 is a circuit diagram of the detector.
[Fig. 14 Fig. 14 is a diagram of an output characteristic obtained from the detector.
[Fig. 15] Fig. 15 is a circuit diagram of a detector according to another embodiment of the present invention.
[Fig. 16] Fig. 16 is a diagram of an output characteristic obtained from a detector according to another embodiment of the present invention.
[Fig. 17] Fig. 17 is a diagram of an output characteristic obtained from a detector according to another embodiment of the present invention.

### Reference Numerals

- 1,101,201,301,401,501: electronic device with a rotation unit
- 2: device main body unit
- 3: rotation unit
- 6a,6b,6c,6d,6e,6f: rotation supporting point
- 7: display unit
- 8,8a,8b,8c,8d: magnet
- 10,110: detector
- 21: element

## Claims

1. An electronic device with a rotation unit, which includes a device main body unit, the rotation unit rotatably supported to the device main body unit, and a display unit provided to the rotation unit, the rotation unit rotating between a closure posture in which the display unit is directed to the device main body unit and a display posture having the display unit remote from the device main body, wherein:
a magnet is provided to one of the device main body unit and the rotation unit, and a detector capable of detecting a direction and an intensity of a magnetic field generated by the magnet is provided to the other;
when the rotation unit is rotated at a predetermined angle from the closure posture to the display posture, the detector detects the magnetic field at a predetermined intensity directed to one direction to obtain a first open detection output; and
when the rotation unit is further rotated to the display posture after obtaining the first open detection output, the detector detects the magnetic field at the predetermined intensity directed to the other direction to obtain a second open detection output.

2. The electronic device with a rotating unit according to Claim 1, wherein when the rotation unit is rotated at an angle in excess of 150° from the closure posture, the second open detection output is obtained from the detector.

3. The electronic device with a rotation unit according to Claim 1 or 2, wherein:
when the first open detection output is obtained by rotating the rotation unit from the closure posture to the display posture, a display of the display unit is turned ON; and
when the second open detection output is obtained, a display content of the display unit is switched.

4. The electronic device with a rotation unit according to Claim 2, wherein when the first open detection output is obtained by rotating the rotation unit from the closure posture to the display posture, a display of the display unit is turned ON, and when the second open detection output is obtained, a content displayed on the display unit is turned upside down.

5. The electronic device with a rotation unit according to Claim 3 or 4, wherein each angle and each direction of the magnet and the detector are set to have a smaller rotating angle of the rotation unit rotated to reach a rotation limited position in the display posture after obtaining the second open detection output compared with the rotating angle of the rotation unit rotated from the closure posture to a position where the first open detection output is obtained.

6. The electronic device with a rotation unit according to any one of Claims 3 to 5, wherein:
when the rotation unit is rotated at a predetermined angle from a rotation limited position in the display posture to the closure posture, a second closure detection output is obtained; and
when the rotation unit is rotated at a predetermined angle to the closure posture after obtaining the second closure detection output, a first closure detection output is obtained.

7. The electronic device with a rotation unit according to Claim 6, wherein a rotating angle of the rotation unit rotated from the rotation limited position to obtain the second closure detection output is larger than a rotating angle of the rotation unit rotated to reach the rotation limited position after obtaining the second closure detection output.

8. The electronic device with a rotation unit according to Claim 7, wherein when the second closure detection output is obtained by rotating the rotation unit from the rotation limited position to the closure posture, the display content of the display unit is returned to an original state.

9. The electronic device with a rotation unit according to any one of Claims 6 to 8, wherein a rotating angle of the rotation unit rotated to reach the closure posture after obtaining the first closure detection output is smaller than a rotating angle of the rotation unit rotated from the closure posture to a position where the first open detection output is obtained.

10. The electronic device with a rotation unit according to Claim 9, wherein when the first closure detection output is obtained by rotating the rotation unit to the closure posture, the display of the display unit is turned OFF.

11. The electronic device with a rotation unit according to any one of Claims 1 to 10, wherein the detector includes a detection element adapted to utilize a magnetoresistance effect.

## Amended claims

### Amended claims under Art. 19.1 PCT

1. (Amended) An electronic device with a rotation unit, which includes a device main body unit, the rotation unit rotatably supported to the device main body unit, and a display unit provided to the rotation unit, the rotation unit rotating between a closure posture in which the display unit is directed to the device main body unit and a display posture having the display unit remote from the device main body, wherein:
a magnet is provided to one of the device main body unit and the rotation unit, and a detector is provided to the other;
different magnetic poles of the magnet are oppositely disposed in a plane orthogonal to a rotating center of the rotation unit;
the detector is a magnetoresistance effect element formed of a fixed magnetic layer having a magnetizing direction fixed and a free magnetic layer having the magnetization changed by an external magnetic field, which is capable of detecting a direction and an intensity of the external magnetic field based on the magnetizing directions of the fixed magnetic layer and the free magnetic layer;
when the rotation unit is rotated at a predetermined angle from the closure posture to the display posture, the detector detects a change in the intensity of the magnetic field in one direction generated by the magnet to obtain a first open detection output; and
when the rotation unit is further rotated to the display posture after obtaining the first open detection output, the detector detects the change in the intensity of the magnetic field in the other direction generated by the magnet to obtain a second open detection output.

2. The electronic device with a rotating unit according to Claim 1, wherein when the rotation unit is rotated at an angle in excess of 150° from the closure posture, the second open detection output is obtained from the detector.

3. The electronic device with a rotation unit according to Claim 1 or 2, wherein:
when the first open detection output is obtained by rotating the rotation unit from the closure posture to the display posture, a display of the display unit is turned ON; and
when the second open detection output is obtained, a display content of the display unit is switched.

4. The electronic device with a rotation unit according to Claim 2, wherein when the first open detection output is obtained by rotating the rotation unit from the closure posture to the display posture, a display of the display unit is turned ON, and when the second open detection output is obtained, a content displayed on the display unit is turned upside down.

5. The electronic device with a rotation unit according to Claim 3 or 4, wherein each angle and each direction of the magnet and the detector are set to have a smaller rotating angle of the rotation unit rotated to reach a rotation limited position in the display posture after obtaining the second open detection output compared with the rotating angle of the rotation unit rotated from the closure posture to a position where the first open detection output is obtained.

6. The electronic device with a rotation unit according to any one of Claims 3 to 5, wherein:
when the rotation unit is rotated at a predetermined angle from a rotation limited position in the display posture to the closure posture, a second closure detection output is obtained; and
when the rotation unit is rotated at a predetermined angle to the closure posture after obtaining the second closure detection output, a first closure detection output is obtained.

7. The electronic device with a rotation unit according to Claim 6, wherein a rotating angle of the rotation unit rotated from the rotation limited position to obtain the second closure detection output is larger than a rotating angle of the rotation unit rotated to reach the rotation limited position after obtaining the second closure detection output.

8. The electronic device according to Claim 7, wherein when the second closure detection output is obtained by rotating the rotation unit from the rotation limited position to the closure posture, the display content of the display unit is returned to an original state.

9. The electronic device with a rotation unit according to any one of Claims 6 to 8, wherein a rotating angle of the rotation unit rotated to reach the closure posture after obtaining the first closure detection output is smaller than a rotating angle of the rotation unit rotated from the closure posture to a position where the first open detection output is obtained.

10. The electronic device with a rotation unit according to Claim 9, wherein when the first closure detection output is obtained by rotating the rotation unit to the closure posture, the display of the display unit is turned OFF.

11. The electronic device with a rotation unit according to any one of Claims 1 to 10, wherein the detector includes a detection element adapted to utilize a magnetoresistance effect.
